# EUROPEAN PATENT APPLICATION

(11) **EP 4 063 533 A1**
(43) Date of publication of application: **28.09.2022**
(21) Application number: 21164953.8
(22) Date of filing: 25.03.2021
(51) Int. Cl.: C23C 18/16, C23C 18/38, C25D 7/06, C25D 5/00, H05K 3/38, C23C 18/40, C23F 3/03, C25D 3/38, C25D 5/18, H05K 3/18

(54) **A PROCESS FOR ELECTROCHEMICAL DEPOSITION OF COPPER WITH DIFFERENT CURRENT DENSITIES**

(71) Applicant: Atotech Deutschland GmbH & Co. KG, 10553 Berlin (DE)
(72) Inventor: Haack, Peter, 10553 Berlin (DE); Peldzinski-Ranisch, Vera, 10553 Berlin (DE); Vazhenin, Grigory, 10553 Berlin (DE); Shin, Hee-Bum, 10553 Berlin (DE); Lee, Jaewon, 10553 Berlin (DE); Bernhard, Tobias, 10553 Berlin (DE)
(74) Representative: Atotech Deutschland GmbH & Co. KG

(57) **Abstract**

A process for electrochemical deposition of copper, comprising
- providing a rolled and annealed copper foil comprising a first surface and a second surface,
- etching the first surface of the rolled and annealed copper foil, thereby creating a first etched surface,
- depositing copper by electroless copper deposition on the first etched surface, thereby creating a first electroless copper layer on the first etched surface,
- depositing further copper by electrochemical deposition on the first electroless copper layer, thereby creating a first electrochemical copper layer, wherein in the electrochemical deposition in a first period of time a first current density is applied and in a second period of time a second current density is applied, wherein the second current density is lower than the first current density, and a layered product obtainable by the process. (Fig. 3)

## Description

### Field of the Invention

The invention relates to a process for electrochemical deposition of copper on RA foils and a layered product obtainable by the process.

### Background of the Invention

A rolled and annealed copper foil, also called "rolled annealed copper foil", or "roll anneal copper foil", and hereinafter also abbreviated as RA copper foil, is known from the prior art in the field of printed circuit boards. An RA copper foil is understood to be a rolled copper foil which is annealed, i.e. subjected to an annealing treatment. Rolling can be done by rolling a copper block or copper billet to obtain the foil of desired thickness, preferably under high pressure. Annealing can be done by heated rolls which can be arranged after non heated rolls. The manufacturing of an annealed copper foil is disclosed e.g. in US2009173414A1.

RA copper foil are known for flexible printed circuit board and small lines. RA copper foils are most commonly used for the metallization of next generation flexible substrates as Flexible printed circuit boards (FPCBs).

Flexible printed circuit boards (FPCBs) are of increasing importance in the electronics industry. One approach to achieve a highly flexible copper foil is a roll-anneal (RA) process that creates a microstructure with large crystallites that are of the order of up to 100 µm wide according to the plane of the foil (highly annealed, HA type copper foils). These crystallites are aligned with their [100] direction along the rolling direction and their [001] direction perpendicular to the surface of the foil (cube texture). This microstructure prevents stress accumulation at grain boundaries upon bending, and therefore metal fatigue by minimizing initial cracking spots. In the production of FPCBs, the RA foils are laminated on flexible polymers as polyimide or other insulating substrates. To produce multi-layer flex circuits, a sequence of further copper plating steps is required. Prior to electroplating electroless plating is used to deposit copper on the parts of the surface that are electrically insulating.

The special crystal structure, particularly for the "super flexible" HA copper foils, however, requires sophisticated plating solutions in order to achieve the desired surface morphology. One major challenge is the surface appearance after the electrolytic copper plating step. The surface must have a certain shiny appearance, in order to enable an even etching during structuring and to ensure a reliable automated optical inspection (AOI).

The crystal structure of RA foils shows a macro-scale inhomogeneous surface after a half-etching process. This leads to matt Cu surface after electroless and subsequent electrochemical Cu plating.

Shiny Cu surfaces for AOI and subsequent processing steps are requested. At the same time, structures like blind micro vias (BMV) and through holes (THF), if present, must be filled. For such filling, low current densities are usually used, at least at the beginning of electrochemical copper deposition. However, by such process, only a matt surface appearance is reached. A matt surface is believed to be caused by the pre-process of etching of RA foils which have a macro-scale inhomogeneous surface as mentioned above.

### Objective of the Invention

The problem of the invention was to provide a method for producing more shiny or glossy copper surfaces in a product comprising an RA copper layer, an electroless copper layer and an electrochemically deposited copper layer.

### Summary of the Invention

The invention provides a process for electrochemical deposition of copper, comprising
- providing a rolled and annealed copper foil comprising a first surface and a second surface,
- etching the first surface of the rolled and annealed copper foil, thereby creating a first etched surface,
- depositing copper by electroless copper deposition on the first etched surface, thereby creating a first electroless copper layer on the first etched surface,
- depositing further copper by electrochemical deposition on the first electroless copper layer, thereby creating a first electrochemical copper layer, wherein in the electrochemical deposition in a first period of time a first current density is applied and in a second period of time a second current density is applied, wherein the second current density is lower than the first current density.

The invention further provides a layered product, comprising:
- a rolled and annealed copper foil comprising a first etched surface and a second surface,
- a first electroless copper layer which is present on the first etched surface of the rolled and annealed copper foil,
- a first electrochemical copper layer which is present on the first electroless copper layer,
wherein the first electrochemical copper layer has an outer surface having a glossiness of at least 400 Gloss Units at an incident angle of 60°.

The solution of the invention is the appliance of at least two different current densities
1. A high initial current density for short time. Without wishing to be bound by theory it is believed that here a thin barrier layer is formed, which avoids that a non-glossiness of a first electroless copper layer on RA copper is maintained even in the next layer, the first electrochemically deposited copper layer.
2. Lower plating current density for a second period of time, preferably the remaining time of electrochemically copper deposition. Here, structures, if present, are filled with copper and distribution of copper over the whole area including structures is reached, wherein the distribution may be uniform, and structures may be filled without dimples or overfilled.

In its general or in specific embodiments, the present invention provides one or more of the following advantages:
- It has been shown that by the process of the invention glossy/shiny surfaces of the electrochemically deposited copper can be obtained.
- The reached glossiness is beneficial for inspection of the copper surface, appearance of the surface and for further process steps, such as structuring the copper surface by e.g. semi-additive processes.
- The process of the invention is suitable to produce precursor products for flexible printed circuit boards.
- Blister-free electroless copper deposition
- The process of the invention enables good coverage and thicker electroless copper deposits, also at critical spots such as the blind micro vias (BMVs) corners or on exposed adhesive layers within vias
- The process of the invention allows for an excellent and blister free adhesion of the electroless deposited copper layer even on smooth substrates like support layers made of PI.

### Brief Description of the Figures

- Fig. 1: shows a process scheme for producing an RA foil;
- Fig. 2: shows a scheme of a process of copper deposition on different substrates;
- Fig. 3: shows a product obtained by the process of Fig. 2 when RA copper foil is used;
- Fig. 4: shows experimental data of glossiness in an example according to the invention vs. comparative examples.

### Detailed description of the Invention

Reference will now be made in detail to embodiments, examples of which are illustrated in the accompanying drawings. Effects and features of the exemplary embodiments, and implementation methods thereof will be described with reference to the accompanying drawings. As used herein, the term "and/or" includes any and all combinations of one or more of the associated listed items. Further, the use of "may" when describing embodiments of the present invention refers to "one or more embodiments of the present invention".

In the following description of embodiments of the present invention, the terms of a singular form may include plural forms unless the context clearly indicates otherwise, e.g. if in the following 'copper foil' is used 'copper foils' is included.

An RA copper foil is understood to be a copper foil which is rolled and annealed, i.e. subjected to a rolling and annealing treatment. Preferably the obtained shape of the crystal is a lamellar structure and consists of huge crystals having grain size of 100 µm according to the plane of the foil. Preferably, RA copper will have an elongated grain structure or elongated crystal structure parallel to the machine direction, which is the direction of the rolling process, i.e. the direction of transportation of the copper foil. Preferably the rolled and annealed copper foil comprises copper crystallites which are aligned with their [100] direction along the rolling direction and their [001] direction perpendicular to the surface of the foil (cube texture [100]). Rolling can be done by rolling a copper block or copper billet to obtain the foil of desired thickness, preferably under high pressure. Annealing can be done by heated rolls which can be arranged after non heated rolls. The invention does not concern copper foils which are not made from copper block or copper billet, in particular copper foils as ECD copper foils which are made by galvanic processes are excluded in the sense of the invention.

The term RA copper foil is understood to encompass so called highly annealed copper foil, hereinafter also abbreviated as HA copper foil. HA copper foil has a large crystal grain and highly uniform crystal orientation. HA copper foil shows very high flexibility.

The rolled and annealed copper foil preferably has a thickness from 6 to 30 µm, more preferred from 10 to 20 µm, even more preferred from 12 to 18 µm before the etching step is applied.

In one embodiment, the provided rolled and annealed copper foil is laminated with a support layer to obtain a laminated substrate before the etching step is conducted. In this embodiment the support layer may comprise a first surface and second surface. That means, the second surface of the provided rolled and annealed copper foil is laminated with a first surface of a support layer to obtain a laminated substrate before the etching step. The support layer is preferably a flexible nonconductive plastic layer, more preferably a plastic foil. The flexible nonconductive plastic layer is for example selected from flexible, nonconducting polymers as polyimide (PI), polyethylene (PE), polypropylene (PP), polycarbonate (PC), Liquid Crystal Polymer (LCP), and cyclic olefin copolymer (COC). The flexible nonconductive plastic layer may be a flexible plastic composite layer or a blended layer of the forgoing polymers, more preferred a polyimide or blends of polyimides.

In another embodiment, a further rolled and annealed copper foil may be laminated on the second surface of said support layer (the second surface of the support layer may be laminated with the first surface of the further rolled and annealed copper foil). In this case the method of the invention may be performed with two of the rolled and annealed copper foils which are laminated on said two surfaces of the support layer in order to obtain a laminated substrate.

The obtained laminated substrate of one or two copper foils and one support layer can be used as a precursor product for the manufacturing of flexible circuit boards e.g. in mobile phones.

The support layer preferably has a thickness from 20 to 70 µm, more preferred from 30 to 50 µm.

In one embodiment, a rolled and annealed copper foil has a thickness of 6 to 30 µm. The copper foil is laminated on a polyimide support layer having a thickness of 20 to 70 µm.

In one embodiment, the laminated substrate (comprising one or two copper foils) can be structured e.g. by laser drilling to obtain blind micro vias and optionally through holes. After structuring, the laminated substrate comprises blind micro vias which are going through the copper foil and ending onto the laminated support layer, and optionally through holes which are going completely through the copper foil and the support layer. With other words, the laminated substrate comprises blind micro vias which are going through from the first surface of the copper foil and ending onto the first surface of support layer or within the support layer, and optionally through holes which are going completely through the copper foil and the support layer. The structuring can be followed by a desmear process and the structuring can be conducted before the etching step or after the etching step.

In one embodiment, the blind micro via has a ratio of width to depth of about 1 : 2 to about 2.5 : 1. A preferred width is in the range of 50 to 150 µm and a preferred depth in the range of 30 to 100 µm, more preferred the blind micro via has a ratio of width to depth in the range from 100 to 40 µm until 70 to 30 µm.

In case of a trough hole, a preferred aspect ratio (width to depth) is from 1 to 3, preferred 1 to 1.5. A preferred width is in the range of 50 to 80 µm, more preferred 70 µm and a preferred depth in the range of 100 to 200 µm, more preferred 110 µm.

### Etching:

Etching the surface of the RA copper foil is also called "half etching". In this step, copper of the RA copper foil is removed partially, wherein a rough copper surface is formed.

The etching step is done by known etching solutions, which can comprise oxidizing agents as e.g. organic or inorganic peroxides and mineral acids as sulfuric or hydrochloric acid, e.g. preferred etching solutions comprise hydrogen peroxide and sulfuric acid. Additionally, the etching solutions can comprise one or more additives and one or more halides to maintain the etch stability. A standard etching solution can be used which comprises H₂O₂/H₂SO₄ and chloride ions.

The etching solutions can be applied by e.g. spraying or immersing.

During the etching step the thickness of the copper layer is preferably reduced by 2 -10 µm, more preferred by 3 - 6 µm.

### Electroless copper deposition

After the etching step, an electroless copper deposition step is done by known aqueous electroless plating solutions e.g. disclosed in EP 2784181 B1. The electroless copper plating solution will most effectively form a copper, preferably a pure copper layer (pure means 99 weight-% or more of copper content), or copper alloy layer, preferably a copper layer (first electroless copper layer) on the surface of the etched rolled and annealed copper foil.

Generally, the electroless plating solution comprises a source of copper ions as copper sulphate, copper chloride, copper nitrate, copper acetate, copper methane sulfonate, copper hydroxide; a source of a reducing agent and a complexing agent for copper or alloying metal ions. The source of reducing agent can be formaldehyde, paraformaldehyde, glyoxylic acid, NaBH₄, KBH₄, NaH₂PO₂, hydrazine, formalin, polysaccharide, such as glucose, and a mixture thereof, and the source of complexing agent can be ethylenediaminetetraacetic acid (EDTA), N'-(2-Hydroxyethyl)-ethylenediamine, N,N,N'-triacetic acid (HEDTA), cyclohexanediamine tetraacetic acid, diethylenetriamine pentaacetic acid, and N. N,N',N'Tetrakis (2-hydroxypropyl)ethylenediamine (Quadrol). Further optional components are mineral acid or a base, stabilizing agents, co-solvents, wetting agents and other functional additives such as brighteners, accelerators, suppressors, anti-tarnish agents. Such solutions and components are known in the art. The electroless copper plating bath may further comprise sources of alloying metal ions as nickel ions, or cobalt ions and mixtures thereof.

The electroless copper plating solutions are known to the public and can be purchased e.g. from Atotech Deutschland GmbH.

| **Process** | **Chemistry** | **Setpoint [mL/L**] | **Temp [°C]** | **Dwell time [min]** |
|---|---|---|---|---|
| | | | | |
| E'less copper (MV TP1) | Printoganth MV Basic TP 1 | 140 | 34 | 20 |
| | Printoganth MV Copper TP 1 | 85 | | |
| | Printoganth MV Moderator TP 1 | 3 | | |
| | Printoganth MV Stabilizer TP 1 | 0,6 mL/L (MU) | | |
| | Cu Reduction Solution | 16 | | |
| | pH-Correction Solution CC | 7 mL/L (3 g/L) | | |

A typical electroless copper plating solution can also comprise nickel ions and cyanide ions can be added. The plating solutions is stabilized by aeration, and during deposition the solution was agitated with a magnetic stirrer. Freshly prepared plating solutions were conditioned by plating for 30 min.

Electroless deposition in preferably done by contacting the etched surface with a copper solution (also called copper bath) for electroless copper deposition.

### Electrochemical deposition of copper

For electrochemical deposition of copper, an aqueous acidic copper plating bath is preferably used. Such baths are known from the prior art, such as EP2922985 and EP3511444.

The expression that the second current density is lower than the first current density preferably means that the second current density is at least 0.2 ASD or more (Ampere per square decimeter; A/dm²) lower than the first current density, preferred by at least 0.2 to 0.5 ASD.

The first current density and/or the second current density may vary, wherein the second current density is always lower than the first current density. The first current density and/or the second current density may have the shape of a declining or inclining ramp. In case that the first current density and/or the second current density vary, it is preferred that the highest value of the second current density is at least 0.2 ASD or more, preferred at least 0.2 to 0.5 ASD lower than the lowest value of the first current density.

The second period of time may immediately follow on the first period of time.

At a transition of the first period of time to the second period of time the difference between the first current density and the second current density may be at least 0.2 ASD or more, preferred at least 0.2 to 0.5 ASD.

In one embodiment, the second current density is in the range of 5 to 80 % of the first current density, preferably 20 -70 %, more preferably 30-40%.

In one embodiment, the second current density is in the range of 0.5 to 2.1 ASD, preferably 0.8 to 1.6 ASD, more preferably 1.0 to 1.3 ASD.

In one embodiment, the first current density is in the range of 1 to 10 ASD, preferably 1 to 4 ASD. As can be seen, the preferred ranges of first/second current density can overlap. According to the invention, the second current density is however always lower than the first current density. So, if for example the first current density is chosen to be 1 ASD, the second current density is below 1 ASD.

In one embodiment, the length of first period of time is in the range of 1 to 25 % of the length of the second period of time, preferably 1 to 10%, more preferably 8 % of the length of the second period of time.

In one embodiment, the first period of time is in the range of 0.5 to 5 minutes, preferably 1 to 4.minutes, more preferably 2 to 4 minutes.

In one embodiment, the second period of time is in the range of 20 to 60 minutes, preferably 30 to 40 minutes, most preferred 50 minutes.

The magnitude of the first current density can be set in relation to the geometry of the blind micro vias or through holes, wherein in case of smaller structures, particularly structures with lower width or lower ratio of width to depth, a lower first current density is preferably chosen, and vice versa.

In one embodiment, an electrochemical copper solution for deposition is used which comprises
- a source of copper ions
- an acid
- a leveler additive, and
- optionally one or more of the following components: an accelerator-brightener additive, a carrier-suppressor additive, and/or halogen ions.

The solution, also called aqueous acidic copper plating bath, preferably has a pH value of ≤ 2, more preferably of ≤ 1.

The source of copper ions is preferably selected from the group comprising copper sulfate and copper alkyl sulfonates such as copper methane sulfonate. The copper ion concentration in the aqueous acidic copper plating bath preferably ranges from 4 g/l to 90 g/l, more preferably 10-70 g/L, still more preferably 30-65 g/L.

The acid is preferably selected from the group comprising sulfuric acid, fluoro boric acid, phosphoric acid and methane sulfonic acid and is preferably added in a concentration of 10 g/l to 400 g/l, more preferably from 20 g/l to 300 g/l, still more preferably 30 g/L to 300 g/L.

The leveler additive is preferably selected from one or more of compounds which is/are selected from the group consisting of an ureylene polymer, nitrogen containing organic compounds such as polyethyleneimine, alkoxylated polyethyleneimine, alkoxylated lactams and polymers thereof, diethylenetriamine and hexamethylenetetramine, polyethylenimine bearing peptides, polyethylenimine bearing amino acids, polyvinylalcohol bearing peptides, polyvinylalcohol bearing amino acids, polyalkyleneglycol bearing peptides, polyalkyleneglycol bearing amino acids, aminoalkylene bearing pyrroles and aminoalkylene bearing pyridines, ureyl polymers, organic dyes such as Janus Green B, Bismarck Brown Y and Acid Violet 7, sulphur containing amino acids such as cysteine, phenazinium salts and derivatives thereof. Said optional leveler additive is added to the aqueous acidic copper plating bath (in total) in amounts of 0.1 mg/l to 100 mg/l. Mentioned ureylene polymer is preferably an ureylene polymer as disclosed in EP2922985A. The accelerator-brightener additive is preferably selected from one or more of compounds which is/are selected from from the group consisting of organic thiol-, sulfide-, disulfide- and polysulfide-compounds, preferably selected from the group consisting of 3-(benzthiazolyl-2-thio)-propylsulfonic-acid, 3-mercaptopropan-1-sulfonic-acid, ethylendithiodipropylsulfonic-acid, bis-(p-sulfophenyl)-disulfide, bis-(w-sulfobutyl)-disulfide, bis-(w-sulfohydroxypropyl)-disulfide, bis-(ω-sulfopropyl)-disulfide, bis-(ω-sulfopropyl)-sulfide, methyl-(ω-sulfopropyl)-disulfide, methyl-(ω-sulfopropyl)-trisulfide, O-ethyl-dithiocarbonic-acid-S-(ω-sulfopropyl)-ester, thioglycol-acid, thiophosphoric-acid-O-ethyl-bis-(ω-sulfopropyl)-ester, 3-N,N-dimethylaminodithiocarbamoyl-1-propanesulfonic acid, 3,3'-thiobis(1-propanesulfonic acid), thiophosphoric-acid-tris-(ω-sulfopropyl)-ester and their corresponding salts. The concentration of all accelerator-brightener additives (in total) optionally present in the aqueous acidic copper bath compositions preferably ranges from 0.01 mg/l to 100 mg/l, more preferably from 0.05 mg/l to 10 mg/l still more preferably 0.1-5 mg/L.

The carrier-suppressor additive is preferably selected from one or more of compounds which is/are selected from the group consisting of polyvinylalcohol, carboxymethylcellulose, polyethylenglycol, polypropylenglycol, stearic acid polyglycolester, alkoxylated naphtoles, oleic acid polyglycolester, stearylalcoholpolyglycolether, nonylphenolpolyglycolether, octanolpolyalkylenglycolether, octanediol-bis-(polyalkylenglycolether), poly(ethylenglycol-ranpropylenglycol), poly(ethylenglycol)-*block*-poly(propylenglycol)-*block*-poly(ethylenglycol), and poly(propylenglycol)-*block*-poly(ethylenglycol)-*block*-poly(propylenglycol). The concentration of said optional carrier-suppressor additives (in total) preferably ranges from 0.005 g/l to 20 g/l, more preferably 0.01 20 g/L, still more preferably from 0.01 g/l to 5 g/l.

Optional halogenide ions are preferably selected from CI, Br, and/or I. In case of chloride, halogenide ions are preferably added in 10-200 mg/L, more preferably 20-80 mg/L, or 30 - 60 mg/L. If other halogenide ion is chosen, a respective molar amount is preferably chosen, or if different halogenides are chosen, a respective total molar amount is chosen.

The aqueous acidic copper plating bath is preferably operated in the method according to the present invention in a temperature range of 15 °C to 50 °C, more preferably in a temperature range of 25 °C to 40 °C by applying an electrical current to the substrate and at least one anode.

If needed, additional steps as rinsing steps e.g. with DI water, cleaner steps; pre-dip steps; and/or drying steps can be conducted between the steps above.

The method of the invention may comprise one or more of the following steps, in any order
- automatic optical inspection
- structuring the copper surface by using known photolithographic processes
- a further etching step
- deposition of one or more further metal layer(s), such as Cu, Ni, Au etc.

In a further aspect, the invention is directed to a layered product which is obtained or obtainable by the process of the invention.

In one embodiment of the layered product, the layer of electrochemically deposited copper has an outer surface having a glossiness of at least 400 gloss units at an incident angle of 60°, measured along the machine direction (MD) of the RA copper foil. A method for measuring the glossiness is given in the examples section. The glossiness is preferably 400 - 800 gloss units, more preferably 400 - 600 gloss units, still more preferably 400-500 gloss units.

In another aspect, the invention provides a layered product, comprising:
- a rolled and annealed copper foil comprising a first etched surface and a second surface,
- a first electroless copper layer which is present on the first etched surface of the rolled and annealed copper foil,
- a first electrochemical copper layer which is present on the first electroless copper layer,
wherein the first electrochemical copper layer has an outer surface having a glossiness of at least 400 Gloss Units at an incident angle of 60°, measured along the machine direction (MD) of the RA copper foil. A method for measuring the glossiness is given in the examples section. The glossiness is preferably 400 - 800 gloss units, more preferably 400 - 600 gloss units, still more preferably 400-500 gloss units.

The intensity of the beam reflected at a reflection angle of 60° can be measured using e.g. a Micro Gloss 60° glossimeter of BYK-Gardner GmbH, which complies with DIN 67530, ISO 2813, ASTM D523 and BS 3900 Part D5

This product can be obtained or is obtainable according to the process of the invention. So, all features described in relation to the process can singly or in combination be feature(s) of the product. The process of the invention can, on the other hand, comprise one or more features that are described in relation to the product.

The first electroless copper layer can be obtained or is obtainable by electroless copper deposition, which was described before.

The first electrochemical copper layer can be obtained or is obtainable by electrochemical copper deposition, which was described before. In preparation of the first electrochemical copper layer by electrochemical deposition in a first period of time a first current density is applied and in a second period of time a second current density is applied, wherein the second current density is lower than the first current density. In this regard also we refer to the above description of the process and the current densities.

The first electroless copper layer preferably has a thickness from 0.1 µm to 4 µm, more preferably from 0.2 µm to 2 µm.

The first electrochemical copper layer preferably has a thickness from 2 µm to 15 µm, more preferably from 4 µm to 12 µm, most preferably from 5 µm to 10 µm

The first electrochemical copper layer is preferably thicker than the first electroless copper layer. The ratio of thickness of the second copper layer to the first copper layer is preferably in the range of 30 : 1 to 3 : 1.

The rolled and annealed copper foil can be laminated to a support layer, preferably a flexible nonconductive plastic layer, such as polyimide layer, as described before. So, in one embodiment of the layered product, the second surface of the rolled and annealed copper foil is laminated with a first surface of a support layer. In this regard, we refer to previous disclosure as to a support layer. In this embodiment, the layered product can be used as a precursor product for flexible circuit boards.

### Examples

### Determination of glossiness:

Glossiness was measured as follows. A measurement beam was applied to the surface of the surface-processed electrolytic copper foil at an incident angle of 60° along the machine direction (MD) of the RA copper foil. The machine direction is the direction of the rolling process, i.e. the direction of transportation of the copper foil. The intensity of the beam reflected at a reflection angle of 60° was measured using a Micro Gloss 60° glossimeter of BYK-Gardner GmbH, which complies with DIN 67530, ISO 2813, ASTM D523 and BS 3900 Part D5.

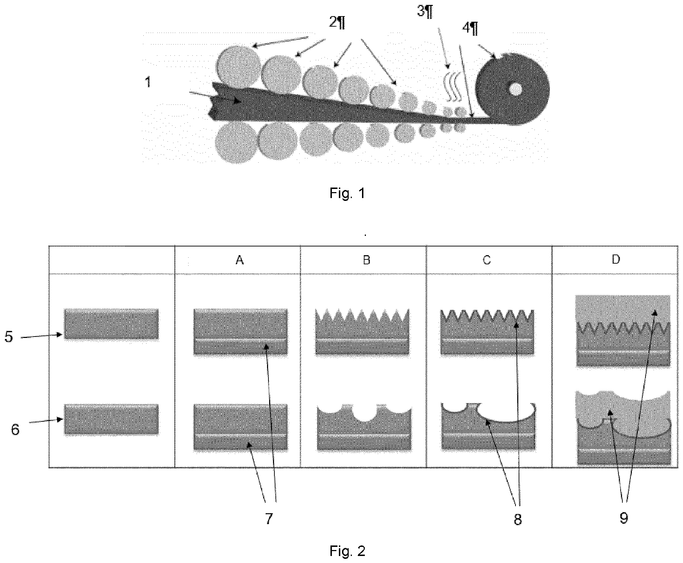

Fig. 1 shows a process scheme for producing an RA foil. A copper ingot 1 is introduced between reducing rolls 2 to reduce thickness. Then the obtained foil is introduced between heated rolls for annealing and then the RA copper foil 4 is obtained and rolled up.

Fig. 2 shows a scheme of a process of copper deposition on different substrates according to the prior art. The upper line in the scheme shows deposition of copper on a copper foil 5 made by electrochemical deposition (ECD copper foil 5). The lower line shows a deposition of copper on a RA copper foil 6. In the first step A, which is not mandatory in the process of the invention, the ECD copper foil 5 and the RA copper foil 6 are laminated onto a plastic foil 7, for example a polyimide foil. Then a so-called half etching step B is done, creating a rough surface on the copper. It can be seen that the surface on the etched RA copper foil 6 is much more inhomogeneous than etched ECD copper foil 5, due to the specific structure of the RA copper, having large crystals / grain structure oriented in in rolling direction. Crystal structure of RA/HA foils shows a macro-scale inhomogeneous surface after half-etching process B due to the copper crystal structure its original method of production. In a next step C electroless copper deposition is done, and a thin electroless copper layer 8 is obtained. Thereby the inhomogeneous surface structure on the RA copper foil 6 is maintained. In the last step D, copper is deposited by electrochemical deposition with one current density and the copper layer 9 is obtained. Thereby the inhomogeneous surface structure on the RA copper foil 6 after etching B is still maintained and carried forward on the surface of the copper layer 9.

If blind micro vias or trenches are created, this was done after step A and before B (i.e. after half etching) or after step B and before step C (before electroless copper deposition. Cleaning and activation steps, for example with Pd, may then be applied).

### Example 1 (comparative)

The comparative example was shown schematically in the lower line in Fig. 2.

Etching B of RA copper foil was done with following solution: 150 ml/L 50 % H₂SO₄, 120 ml/L 30 % H₂O₂, 2 mg/L chloride (NaCI).

Then, electroless copper deposition C was done with following copper bath:

**Table 1: Bath and operating conditions:**

| | **Concentration** |
|---|---|
| [Cu²⁺] | 2.2 g/L |
| [KNaC₄H₄O₆-4H₂O] | 35 g/L |
| [HCHO] | 4.4 g/L |
| [NaOH] | 9 g/L |
| [Ni²⁺] | 0.5 g/L |
| [NaCN] | 0.01 g/L |
| temperature | 32°C |
| pH | 12.5 |
| plating time | 15 - 20 min |

Electrochemical deposition D of copper was done with an acidic copper bath known from EP 2922985 A: aqueous acidic copper electrolyte comprising 55 g/L copper ions, 50 g/L sulfuric acid, 50 mg/L chloride ions, 3 ml/L of SPS.

Electrochemical deposition was done for 4 min with 0.7 ASD and 48 min with 1.3 ASD.

### Example 2 (comparative)

The same procedure was used as in Example 1, except that electrochemical deposition was done for 50 min with 1.3 ASD

### Example 2 (invention)

The same procedure was used as in Examples 1 and 2, except that electrochemical deposition was done for 4 min (first period of time) with 2.6 ASD (first current density) and then for 42 min (second period of time) with 1.3 ASD (second current density).

### Results

Glossiness was measured according the method described above.

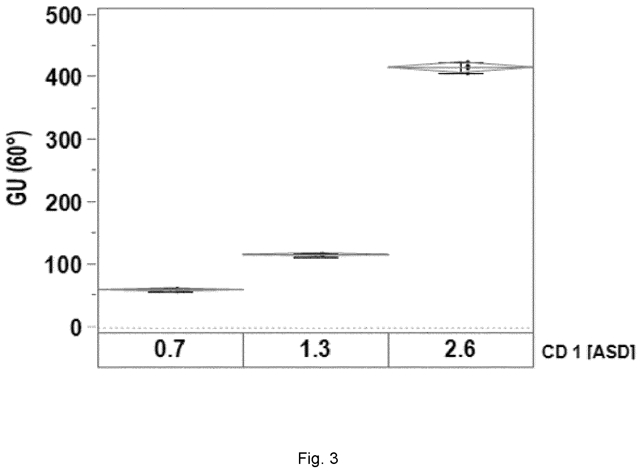

In Fig. 3, the results are shown. From left to right, Example 1, Ex. 2 and Ex. 3 are shown. It can be seen that a gloss of the outer copper surface of about 425 units was reached in the example of the invention, whereas in example 1 a gloss of only about 60 units and in example 2 a gloss of only about 120 units was reached, respectively. These results demonstrate the effect of the invention that when a in a first period of time a first current density is applied and in a second period of time a second current density is applied, wherein the second current density is lower than the first current density, a surface with higher glossiness can be obtained.

Additionally, it could be found, that:
- The higher the initial (4 min) current density the higher the gloss
- Half-etched samples are more sensitive to parameter changes than non-etched ones

## Claims

1. A process for electrochemical deposition of copper comprising the following steps:
- providing a rolled and annealed copper foil comprising a first surface and a second surface,
- etching the first surface of the rolled and annealed copper foil, thereby creating a first etched surface,
- depositing copper by electroless copper deposition on the first etched surface, thereby creating a first electroless copper layer on the first etched surface,
- depositing further copper by electrochemical deposition on the first electroless copper layer, thereby creating a first electrochemical copper layer, wherein in the electrochemical deposition in a first period of time a first current density is applied and in a second period of time a second current density is applied, wherein the second current density is lower than the first current density.

2. The process of claim 1, wherein second current density is in the range of 1 to 50 % of the first current density.

3. The process of claim 1 or 2, wherein second current density is in the range of 0.5 to 2.1 ASD.

4. The process of any of the preceding claims, wherein first current density is in the range of 1 to 10 ASD.

5. The process of any of the preceding claims, wherein the length of the first period of time is in the range of 1 to 25 % of the length of the second period of time.

6. The process of any of the preceding claims, wherein the first period of time is in the range of 0.5 to 5 minutes

7. The process of any of the preceding claims, wherein the second period of time is in the range of 20 to 45 minutes.

8. The process of one of the preceding claims, wherein the second surface of the provided rolled and annealed copper foil is laminated with a first surface of a support layer to obtain a laminated substrate before the etching step.

9. The process of claim 8, wherein the copper foil of the laminated substrate comprises blind micro vias which are going through from the first surface of the copper foil and ending onto the first surface of support layer or within the support layer, and optionally through holes which are going completely through the copper foil and the support layer.

10. The process of claim 9, wherein the blind micro vias have a ratio of width to depth of 1 : 2 to 2.5 : 1.

11. The process of claim 9, wherein the blind micro vias have a width of 50 to 150 µm and a depth of 30 to 100 µm.

12. The process of one of the claims 8 - 11, wherein the support layer is a flexible nonconductive plastic layer.

13. The process of one of the claims 8 - 12, wherein the support layer has a thickness from 20 to 70 µm.

14. A layered product, comprising:
- a rolled and annealed copper foil comprising a first etched surface and a second surface,
- a first electroless copper layer which is present on the first etched surface of the rolled and annealed copper foil,
- a first electrochemical copper layer which is present on the first electroless copper layer,
wherein the first electrochemical copper layer has an outer surface having a glossiness of at least 400 Gloss Units at an incident angle of 60°.

15. The layered product of claim 14, wherein the second surface of the rolled and annealed copper foil is laminated with a first surface of a support layer.
